Europäisches Patentamt

European Patent Office

Office européen des brevets

(19)

(11) Veröffentlichungsnummer : **0 035 122**
**B1**

(12) **EUROPÄISCHE PATENTSCHRIFT**

(45) Veröffentlichungstag der Patentschrift :
**11.04.84**

(21) Anmeldenummer : **81100748.3**

(22) Anmeldetag : **03.02.81**

(51) Int. Cl.³ : **G 01 N 27/00**, G 01 N 27/72,
G 01 R 33/12

(54) **Prüfverfahren zur Ermittlung der magnetischen Eigenschaften ferromagnetischer Pulver.**

(30) Priorität : **22.02.80 DE 3006626**

(43) Veröffentlichungstag der Anmeldung :
**09.09.81 Patentblatt 81/36**

(45) Bekanntmachung des Hinweises auf die Patenterteilung : **11.04.84 Patentblatt 84/15**

(84) Benannte Vertragsstaaten :
**AT DE FR GB IT**

(56) Entgegenhaltungen :
**DD-U-      1 602**
**DE-C- 2 222 657**
**US-A- 3 448 375**
**SOVJET INVENTION ILLUSTRATED Week B 32, 21**
**September 1979**
**MESSEN + PRÜFEN / AUTOMATIK, März 1977 W.**
**WUICH "Magnetpulver-Prüftechnik für den Prakti-**
**ker", Seiten 133 bis 136**

(73) Patentinhaber : **HOECHST AKTIENGESELLSCHAFT**
**Postfach 80 03 20**
**D-6230 Frankfurt am Main 80 (DE)**

(72) Erfinder : **Krämer, Horst, Dr.**
**Kriemhildstrasse 3**
**D-5030 Hürth (DE)**
Erfinder : **Fassbender, Heinrich**
**von-Geyr-Ring 61 d**
**D-5030 Hürth (DE)**

Prüfverfahren zur Ermittlung der magnetischen Eigenschaften ferromagnetischer Pulver

Die vorliegende Erfindung betrifft ein Prüfverfahren zur Ermittlung der magnetischen Eigenschaften von ferromagnetischen Pulvern für Schweretrüben zur Schwimm-Sink-Aufbereitung von Mineralien.

Als Schwimm-Sink-Aufbereitung bezeichnet man die Trennung von Mineralien verschiedener Dichte mit der wäßrigen Suspension eines Schwerstoffes, der sog. Schwertrübe, deren spezifisches Gewicht zwischen den Dichten der zu trennenden Mineralien liegt, wodurch beim Einbringen des Mineralgemenges in die Schwerstoff-Suspension der leichtere Anteil aufschwimmt. Da ein Teil der Schwerstoff-Suspension am aufgeschwommenen und am abgesunkenen Anteil anhaftet, werden beide Anteile nach ihrer Trennung abgebraust, so daß der vorher anhaftende Schwerstoff in Form einer verdünnten Suspension zurückgewonnen wird. Die Abtrennung des Schwerstoffes aus dieser verdünnten Suspension ist wegen der geringen Korngröße des Schwerstoffes beispielsweise durch Filtration nicht möglich. Deswegen werden als Schwerstoffe bevorzugt ferromagnetische Pulver verwendet, welche aus der verdünnten Suspension durch Magnetscheidung zurückgewonnen und darüberhinaus von unmagnetischen Verunreinigungen befreit werden können. So eignet sich in erster Linie Magnetit zur Herstellung von Schwerstoff-Suspension mit niedrigem und Ferrosilicium mit 8 bis 25 % Si zur Herstellung von solcher mit höherem spezifischem Gewicht, wobei der Kornbereich der durch Verdüsen oder Vermahlen hergestellten Schwerstoffe zwischen 0,001 und 0,4 mm liegt. Die zurückgewonnenen Schwerstoffe, welche durch die Magnetscheidung magnetisiert werden, müssen vor ihrem erneuten Einsatz zur Bereitung von Schwerstoff-Suspensionen entmagnetisiert werden, da magnetisierte Pulver keine stabilen Suspensionen bilden. Die Entmagnetisierung des zurückgewonnenen Schwerstoffes kann durch Erhitzen auf Temperaturen oberhalb seines Curie-Punktes oder, weniger aufwendig, durch Abmagnetisierung im Wechselfeld erfolgen. Je nach Produktionslage und in Abhängigkeit von Qualität und Menge der Ausgangsmaterialien können Schwerstoff-Pulver mit mehr oder weniger guten magnetischen Eigenschaften hergestellt werden, was Auswirkungen auf ihre Fähigkeit hat, im Wechselfeld abmagnetisiert zu werden. Besonders wenn zur Erhöhung der Korrosionsbeständigkeit des Schwerstoffes weitere Komponenten, beispielsweise bei Ferrosilicium außer Kohlenstoff noch Phosphor, Kupfer, Aluminium u. a., zugesetzt werden (vergl. DE-C-972 687 und DE-C-2 222 657), entsteht ein bezüglich seiner magnetischen Eigenschaften unübersichtliches Vielstoffsystem.

Es ist daher Aufgabe der vorliegenden Erfindung, ein einfach auszuführendes Prüfverfahren anzugeben, welches die Beurteilung von ferromagnetischen Pulvern in Bezug auf ihre Eignung für Schwertrüben zur Schwimm-Sink-Aufbereitung erlaubt. Ein solches Verfahren ist erfindungsgemäß dadurch gekennzeichnet, daß man

a) das ferromagnetische Pulver in einem magnetischen Gleichfeld mit Feldstärken von 600 bis 1 000 A/cm magnetisiert ;

b) das magnetisierte ferromagnetische Pulver in einem zyklisch abnehmenden magnetischen Wechselfeld mit Feldstärken von 1 000 bis 1 500 A/cm abmagnetisiert ;

c) eine Menge von 0,2 bis 0,5 g des nach a) und b) vorbehandelten ferromagnetischen Pulvers im Mittelpunkt einer kreisförmigen Platte aus dielektrischem Material aufhäuft ;

d) die kreisförmige Platte auf eine Spule mit Eisenkern auflegt, wobei Spule und Eisenkern so dimensioniert sind, daß nach Anlegen einer Wechselspannung von 180 bis 260 V an die Spule in der Mitte der kreisförmigen Platte magnetische Wechselfelder mit Feldstärken von 180 bis 220 A/cm auftreten ;

e) die aus dem aufgehäuften ferromagnetischen Material entstehende Figur betrachtet, wobei eine geschlossene Zentralfigur die unbeschränkte Eignung des ferromagnetischen Pulvers zum Einsatz in Schweretrüben anzeigt.

Dabei kann als dielektrisches Material Glas dienen.

Mit dem Prüfverfahren gemäß der vorliegenden Erfindung kann in einfacher Weise festgestellt werden, ob ein erzeugtes ferromagnetisches Pulver einerseits magnetisierbar genug ist, um durch Magnetscheidung zuverlässig von wäßriger Phase abgetrennt werden zu können, und ob dieses Pulver andererseits magnetisch weich genug ist, um hinreichend abmagnetisiert werden zu können.

In der beigefügten Zeichnung zeigen

Figur 1 eine perspektivische, teilweise im Schnitt dargestellte Einrichtung zur Durchführung des erfindungsgemäßen Prüfverfahrens ;

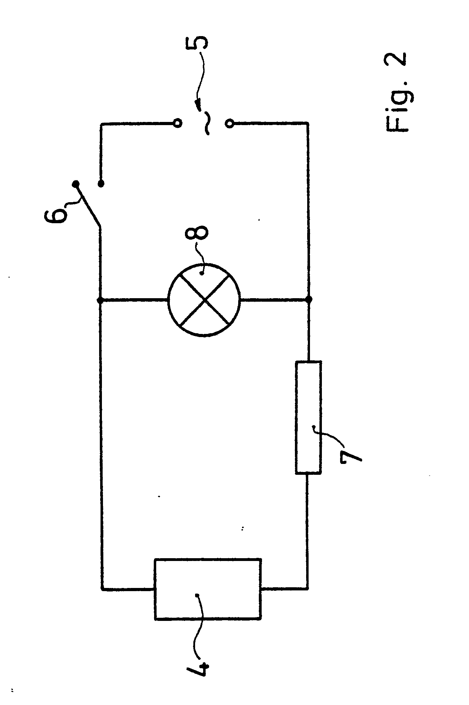

Figur 2 ein elektrisches Schaltbild zum Betrieb der Einrichtung nach Figur 1 ;

Figur 3 photographische Aufnahmen in der Draufsicht auf die Einrichtung nach Figur 1.

In einem Gehäuse 1 ist eine Spule 4 angeordnet, in welche ein Eisenkern 3 eingeschoben ist. Auf dem Eisenkern 3 liegt als kreisförmige Platte zentrisch eine aus Glas bestehende Petrischale 2 auf.

Die Spule 4 ist in einem Stromkreis mit dem Wechselstromnetz 5 verbunden, wobei im Stromkreis ein Schalter 6 und ein Widerstand 7 in Reihe mit der Spule 4 geschaltet sind, während sich eine Glimmlampe 8 in Parallelschaltung zur Spule 4 befindet.

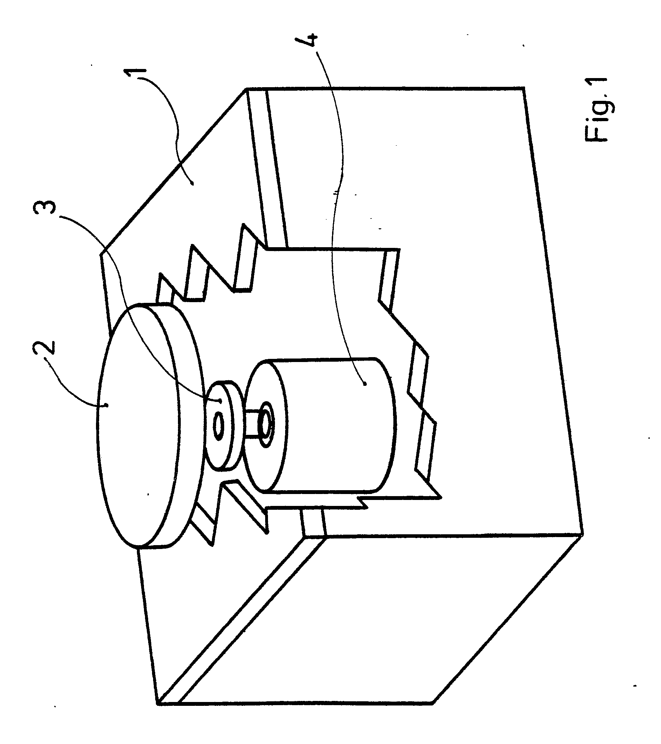

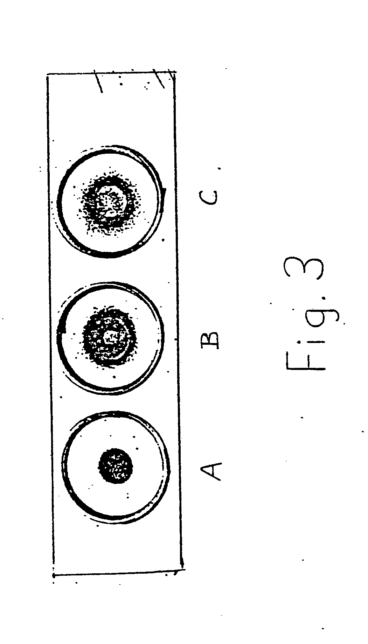

In Figur 3 stellen die äußeren schwarzen Kreise jeweils den Rand der Petrischale 2 gemäß Figur 1 dar, während die inneren geschwärzten Zonen das ferromagnetische Material wiedergeben. Dabei zeigt Photo A eine geschlossene Zentralfigur, während Photo B konzentrisch zu einer aufgehellten Innenzone Ansätze eines schmalen hellen Ringes aufweist. Schließlich zeigt das Photo C eine große helle Innenzone, welche von einem Ring aus ferromagnetischem Material umgeben ist.

Ferromagnetisches Material mit einer Figur nach Photo A ist zum Einsatz in Schwertrüben hervorragend geeignet. Ferromagnetisches Material mit einer Figur nach Photo B ist für diesen Zweck bedingt geeignet, solches mit einer Figur nach Photo C ist ungeeignet.

Beispiel 1

Ferrosilicium-Pulver, welches 12 % Si und 0,7 % P enthielt, wurde in einem magnetischen Gleichfeld mit einer Feldstärke von 600 A/cm magnetisiert und anschließend in einem zyklisch abnehmenden Wechselfeld mit einer Feldstärke von 1 000 A/cm abmagnetisiert. 0,3 g des so vorbehandelten Ferrosilicium-Pulvers wurden auf das Zentrum einer Petrischale von 9 cm Durchmesser aufgegeben, welche gemäß Figur 1 auf einem Eisenkern auflag, der in eine Magnetspule mit 2 000 Windungen eingeschoben war. Nach Anlegen einer Wechselspannung von 220 V über einen Vorwiderstand von 700 Ω an die Spule betrug die magnetische Wechselfeldstärke im Zentrum der Petrischale 200 A/cm.

Unter dem Einfluß des Spulenfeldes ordnete sich das Ferrosilicium-Pulver zu einer geschlossenen Zentralfigur um den Mittelpunkt der Petrischale wie in Photo A an, d. h. das geprüfte Pulver ist zum Einsatz in Schweretrüben zur Schwimm-Sink-Aufbereitung von Mineralien unbeschränkt geeignet.

Beispiel 2

Es wurde ein Ferrosiliciumpulver, welches neben 12 % Si 3,6 % P enthielt, wie in Beispiel 1 angegeben geprüft. Unter dem Einfluß des Spulenfeldes ordnete sich das Ferrosilicium-Pulver in zwei Kreisringen um den freibleibenden Mittelpunkt der Petrischale an (vergl. Photo B), d. h. das geprüfte Pulver ist zum Einsatz in Schwertrüben nur beschränkt geeignet.

Beispiel 3

Es wurde ein Ferrosilicium-Pulver, welches neben 12 % Si 6 % P enthielt, wie in Beispiel 1 angegeben geprüft. Unter dem Einfluß des Spulenfeldes ordnete sich das Ferrosilicium-Pulver in einem Kreisring mit großem Durchmesser um den freibleibenden Mittelpunkt der Petrischale an (vergl. Photo C), d. h. das geprüfte Pulver ist zum Einsatz in Schwertrüben ungeeignet.

**Ansprüche**

1. Prüfverfahren zur Ermittlung der magnetischen Eigenschaften von ferromagnetischen Pulvern für Schwertrüben zur Schwimm-Sink-Aufbereitung von Mineralien, dadurch gekennzeichnet, daß man

a) das ferromagnetische Pulver in einem magnetischen Gleichfeld mit Feldstärken von 600 bis 1 000 A/cm magnetisiert ;

b) das magnetisierte ferromagnetische Pulver in einem zyklisch abnehmenden magnetischen Wechselfeld mit Feldstärken von 1 000 bis 1 500 A/cm abmagnetisiert ;

c) eine Menge von 0,2 bis 0,5 g des nach a) und b) vorbehandelten ferromagnetischen Pulvers im Mittelpunkt einer kreisförmigen Platte aus dielektrischem Material aufhäuft ;

d) die kreisförmige Platte auf eine Spule mit Eisenkern auflegt, wobei Spule und Eisenkern so dimensioniert sind, daß nach Anlegen einer Wechselspannung von 180 bis 260 V an die Spule in der Mitte der kreisförmigen Platte magnetische Wechselfelder mit Feldstärken von 180 bis 220 A/cm auftreten ;

e) die aus dem aufgehäuften ferromagnetischen Material entstehende Figur betrachtet, wobei eine geschlossene Zentralfigur die unbeschränkte Eignung des ferromagnetischen Pulvers zum Einsatz in Schwertrüben anzeigt.

2. Prüfverfahren nach Anspruch 1, dadurch gekennzeichnet, daß als dielektrisches Material Glas dient.

**Claims**

1. Testing method for determining the magnetic properties of ferromagnetic powders for heavy media in the floatsink dressing of minerals, which comprises :

a) magnetizing the ferromagnetic powder in a magnetic steady field at field intensities of 600 to 1,000 amperes per cm ;

b) demagnetizing the magnetized ferromagnetic powder in a cyclicly decreasing magnetic alternating field at field intensities of 1,000 to 1,500 amperes per cm ;

c) heaping up, in the center portion of a circular plate made from dielectric material, 0.2 to 0.5 g of the ferromagnetic powder pretreated as described under a) and b) ;

d) placing the circular plate on an iron core-provided coil, the coil and iron core having the dimensions necessary to effect, in the center portion of the circular plate, the occurrence of alternating fields with field intensities of 180 to 220 amperes per cm after application of an alternating current of 180 to 260 volts to the coil ;

e) observing the heaped ferromagnetic powder for the figure it is forming, the formation of a closed central figure indicating unlimited suitability of the ferromagnetic powder for use in heavy medium suspensions.

2. Testing method as claimed in claim 1, wherein glass is used as the dielectric material.

**Revendications**

1. Procédé d'étude pour déterminer les propriétés magnétiques de poudres ferromagnétiques pour liqueurs denses destinées à la préparation de minerais par flottation et sédimentation, caractérisé en ce que :

a) on aimante la poudre ferromagnétique dans un champ magnétique continu à des intensités de champ de 600 à 1 000 ampères par cm ;

b) on désaimante la poudre magnétique aimantée dans un champ magnétique alternant diminuant cycliquement à des intensités de champ de 1 000-1 500 ampères par cm ;

c) on amasse, au milieu d'une plaque circulaire en matériau diélectrique, une quantité de 0,2-0,5 g de la poudre ferromagnétique traitée selon a) et b) ;

d) on place la plaque circulaire sur une bobine à noyau en fer, la bobine et le noyau en fer présentant les dimensions nécessaires pour provoquer dans le milieu de la plaque circulaire, l'apparition de champs magnétiques alternants d'intensités de champ de 180-220 ampères par cm, après application d'une tension alternative de 180-260 volts ;

e) on observe la figure formée par le matériau ferromagnétique amassé, la formation d'une figure centrale fermée indiquant l'aptitude illimitée de la poudre ferromagnétique pour l'utilisation dans des liqueurs denses.

2. Procédé d'étude selon la revendication 1 caractérisé en ce que le verre sert de matériau diélectrique.

Fig. 1

0 035 122

Fig. 2

0 035 122

Fig. 3